(19) Europäisches Patentamt

European Patent Office

Office européen des brevets

(11) **EP 1 133 060 B1**

(12) **FASCICULE DE BREVET EUROPEEN**

(45) Date de publication et mention
de la délivrance du brevet:
**17.08.2005 Bulletin 2005/33**

(51) Int Cl.$^7$: **H03L 7/197**, H03L 7/081

(21) Numéro de dépôt: **01200808.2**

(22) Date de dépôt: **05.03.2001**

(54) **Boucle à verrouillage de phase permettant de générer un signal de référence ayant une grande pureté spectrale**

Phasenregelschleife zur Erzeugung eines Referenzsignals hoher spektraler Reinheit

Phase locked loop for generating a reference signal having a high spectral purity

(84) Etats contractants désignés:
**DE FR GB**

(30) Priorité: **10.03.2000 FR 0003134**

(43) Date de publication de la demande:
**12.09.2001 Bulletin 2001/37**

(73) Titulaire: **Koninklijke Philips Electronics N.V.
5621 BA Eindhoven (NL)**

(72) Inventeurs:
• **Canard, David
75008 Paris (FR)**
• **Fillatre, Vincent
75008 Paris (FR)**

(74) Mandataire: **Chaffraix, Jean
Société Civile SPID,
156, Boulevard Haussmann
75008 Paris (FR)**

(56) Documents cités:
**FR-A- 2 474 258        GB-A- 2 097 206
GB-A- 2 150 775        US-A- 4 686 488**

• **COSMO LITTLE: "FRACTIONAL-N SYNTHESIS"
ELECTRONICS WORLD AND WIRELESS
WORLD,GB,REED BUSINESS PUBLISHING,
SUTTON, SURREY, vol. 102, no. 1719, 1 février
1996 (1996-02-01), pages 130-135, XP000553560
ISSN: 0959-8332**

**Description**

La présente invention concerne une boucle à verrouillage de phase telle que définie dans le préambule de la revendication 1.

Dans la plupart des boucles à verrouillage de phase connues, le diviseur de fréquence reçoit le signal de sortie de l'oscillateur et délivre à un comparateur de phase/fréquence un signal de sortie ayant une fréquence N fois inférieure à la fréquence d'oscillation, où N est une valeur entière égale à celle d'un mot de consigne. Le comparateur phase/fréquence compare cette fréquence avec une fréquence, dite de comparaison, d'un signal de comparaison qui provient, par exemple, d'un oscillateur à quartz. Lorsque la fréquence de sortie du diviseur de fréquence est inférieure à la fréquence de comparaison, le comparateur phase/fréquence commande une augmentation de la fréquence d'oscillation, jusqu'à ce que la fréquence d'oscillation soit égale à N fois la fréquence de comparaison. La valeur de la fréquence de comparaison étant fixée, le choix de la valeur N du mot de consigne détermine la valeur de la fréquence d'oscillation. L'écart minimum entre deux valeurs de la fréquence d'oscillation est donc égal à la valeur de la fréquence de comparaison. Il a été constaté que les performances en bruit d'une boucle à verrouillage de phase sont d'autant meilleures que la fréquence de comparaison est élevée. Néanmoins, choisir une fréquence de comparaison élevée revient à augmenter la valeur de l'écart minimum entre deux valeurs de la fréquence d'oscillation, cet écart étant, lui, déterminé par les conditions dans lesquelles la boucle à verrouillage de phase est employée. Ainsi, dans des applications où le signal de sortie de l'oscillateur est utilisé pour la réception de signaux télévision numériques hertziens, cet écart minimum est prédéterminé et fixé à 166,67kHz par la norme OFDM.

Pour maintenir un écart minimum constant tout en augmentant la valeur de la fréquence de comparaison, il est alors nécessaire d'utiliser un diviseur de fréquence dont le rapport de division a une valeur non-entière. De tels diviseurs de fréquence sont connus sous l'appellation «fractionnel-N». Leur rapport de division est déterminé par au moins deux paramètres.

Pour un grand nombre de diviseurs de type fractionnel-N connus, le rapport de division R peut s'exprimer sous la forme R=N+k/q, où N et k sont des premier et deuxième paramètres entiers, q étant un troisième paramètre entier dont la valeur est prédéterminée par la valeur de l'écart minimum entre deux fréquences d'oscillation, qui doit être maintenu constant. Ainsi, q=FCOMP/FSTEP, où FCOMP est la fréquence de comparaison choisie et FSTEP l'écart minimum.

De tels diviseurs de fréquence opèrent une division par N pendant q-k cycles de fonctionnement de la boucle à verrouillage de phase, un cycle de fonctionnement correspondant à une période du signal de sortie du diviseur de fréquence, puis une division par N+1 pendant k cycles de fonctionnement de ladite boucle. Ainsi, la valeur moyenne du rapport de division sur q cycles de la boucle à verrouillage de phase est égale à N+k/q. Un régime d'équilibre de la boucle à verrouillage de phase est défini comme étant celui au cours duquel est vérifiée la relation suivante : FDIV=FLO/R=FCOMP, où FDIV est la fréquence du signal de sortie du diviseur de fréquence, et

FLO et FCOMP sont respectivement les fréquences d'oscillation et de comparaison.

Cela signifie qu'à l'issue de q cycles de fonctionnement de la boucle à verrouillage de phase, le signal de sortie du diviseur de fréquence et le signal de comparaison doivent être en phase et avoir des fréquences égales, c'est-à-dire qu'à l'issue de q cycles de fonctionnement, aucune correction ne doit être en principe apportée à la valeur de la fréquence d'oscillation.

Or, on constate en réalité qu'à l'issue de chaque cycle au cours duquel le rapport de division du diviseur de fréquence est égal à N, le signal de sortie du diviseur de fréquence présente un déphasage par rapport au signal de comparaison, puisque sa fréquence FDIV est légèrement plus élevée que la fréquence de comparaison FCOMP, FDIV étant égale à FLO/N, tandis que FCOMP=FLO/(N+k/q). Bien que de tels déphasages se trouvent théoriquement compensés lors des cycles au cours desquels le rapport de division du diviseur de fréquence est égal à N+1, en pratique, tout déphasage est détecté par le détecteur de phase/fréquence qui provoque automatiquement une correction inutile et intempestive de la valeur de la fréquence d'oscillation. De telles corrections génèrent une modulation de phase parasite du signal de sortie de l'oscillateur autour de sa fréquence d'oscillation centrale, c'est-à-dire que la valeur instantanée de la fréquence d'oscillation varie au cours du régime d'équilibre.

Or, une boucle à verrouillage de phase a pour principale fonction de générer un signal ayant une fréquence d'oscillation précisément définie destiné à être utilisé comme référence, par exemple par des convertisseurs de fréquence inclus dans des syntoniseurs destinés à la réception de signaux radioélectriques, au sein de téléviseurs ou des radiotéléphones, entre autres applications possibles.

Un signal entaché d'une modulation de phase parasite est impropre à un tel usage.

La demande de brevet français publiée sous le numéro 2 474 258 décrit un synthétiseur de fréquence du type à boucle de réaction à accrochage de phase. Le synthétiseur comprend un oscillateur réglable en fréquence qui produit une fréquence de sortie à partir d'un signal de contrôle de fréquence. Un multiplicateur de taux par additions successives fournit un signal de correction pour éliminer une variation dans le signal de contrôle de fréquence. L'élimination de cette variation est améliorée au moyen d'une boucle à réaction. Cette boucle détecte une variation résiduelle et adapte automatiquement le signal de correction.

La présente invention a pour but de remédier dans une large mesure à l'inconvénient que présente une modulation de phase parasite, en proposant une boucle à verrouillage de phase qui offre de bonnes performances en bruit grâce à l'utilisation d'un diviseur de fréquence fraetionnel-N, sans pour autant que ledit diviseur n'introduise une modulation de phase parasite dans le signal de sortie de l'oscillateur dont la fréquence d'oscillation est régulée par la boucle.

La revendication 1 définit une boucle à verrouillage de phase selon l'invention.

Dans la boucle à verrouillage de phase conforme à l'invention, les signaux d'entrée du détecteur de phase/fréquence sont rendus synchrones pendant le régime d'équilibre. Le détecteur de phase/fréquence ne provoque donc plus de corrections intempestives, ce qui conduit à la disparition de la modulation de phase parasite du signal de sortie de l'oscillateur.

Il est à noter en outre que l'invention permet l'élimination de la modulation parasite à l'intérieur même de la boucle à verrouillage de phase, de façon automatique et sans nécessité d'aucune intervention extérieure.

Selon l'invention, des moyens de correction incluent :

- des moyens de stockage pour mémoriser la valeur prise par le signal de réglage à l'issue de q cycles de la boucle à verrouillage de phase, et
- des moyens de déphasage pour appliquer au signal de comparaison, à chaque ième (pour i=1 à q) cycle de la boucle à verrouillage de phase, un déphasage dont la valeur est déterminée par le produit entre la valeur mémorisée par les moyens de stockage et un coefficient $L(i)$ propre au cycle considéré.

Ainsi, une valeur non-nulle du signal de réglage à l'issue de q cycles de fonctionnement de ladite boucle signale l'existence d'une modulation de phase parasite du signal de sortie de l'oscillateur. La valeur de ce signal de réglage conditionne l'ampleur des déphasages à imprimer au signal de comparaison afin qu'il soit affecté d'une modulation de phase identique à la modulation de phase parasite. Au fil du temps, l'ampleur de la modulation parasite diminue, du fait de la correction ainsi effectuée, ce qui implique une diminution graduelle de la valeur mémorisée par les moyens de stockage, et donc une diminution automatique, du fait de la nature particulière des moyens de déphasage décrits ci-dessus, de l'ampleur des corrections apportées à la phase du signal de comparaison. Lorsque la valeur devient nulle, plus aucune correction n'est appliquée au signal de comparaison.

Les moyens de déphasage décrits ci-dessus permettent d'appliquer au signal de comparaison, au cours de chaque cycle de fonctionnement de la boucle à verrouillage de phase, un déphasage tel que le signal de comparaison ainsi obtenu et le signal de sortie du diviseur de fréquence soient en phase à l'issue dudit cycle, quelle que soit la valeur du rapport de division au cours de ce cycle. En effet, la valeur du coefficient $L(i)$ est déterminée pour chaque cycle en tenant compte du rapport de division utilisé au cours de ce cycle. Les valeurs des coefficients $L(i)$ seront avantageusement choisies au moyens des relations :

$$L(i)=L(i-1)+k, \text{ si } L(i-1)<q,$$

et

$$L(i)=L(i-1)-q, \text{ si } L(i-1)>q.$$

De multiples modes de réalisation des moyens de déphasage sont envisageables et à la portée de l'homme du métier. Un mode de réalisation particulièrement avantageux tire parti du fait que le signal de comparaison, provenant le plus souvent d'un oscillateur à quartz ayant de caractéristiques bien identifiées, présente une allure linéaire au voisinage de la valeur zéro, les passages par zéro du signal de comparaison constituant les évènements par rapport auxquels des fronts du signal de sortie du diviseur de fréquence sont comparés.

Un décalage en tension du signal de comparaison provoque alors un décalage temporel desdits passages par zéro, décalage dont la valeur est proportionnelle à celle du décalage en tension. Dans ce mode de réalisation de invention, les moyens de déphasage seront donc avantageusement agencés pour appliquer au signal de comparaison, au cours de chaque ième (pour i=1 à q) cycle de la boucle, un décalage en tension dont l'ampleur est proportionnelle à $L(i)$ fois la valeur mémorisée par les moyens de stockage.

On a vu précédemment que des boudes à verrouillage de phase utilisant un diviseur de fréquence fractionnel-N sont avantageusement mises en oeuvre pour générer des signaux de référence permettant dès conversions de fréquence, tout en offrant de bonnes performances en bruit, dans certaines applications où l'écart minimum séparant deux fréquences d'oscillation a une valeur imposée. Dans un mode de mise en oeuvre de telles boucles à verrouillage de phase, l'invention concerne donc un appareil destiné à la réception de signaux radioélectriques, par exemple un téléviseur ou un radiotéléphone, induant :

- un étage d'entrée destiné à recevoir un signal radioélectrique et à convertir ledit signal en un signal de sortie électronique ayant une fréquence dite fréquence radio,
- une boucle à verrouillage de phase telle que décrite plus haut, destinée à ajuster la fréquence d'oscillation du signal de sortie d'un oscillateur, et
- un mélangeur destiné à recevoir les signaux de sortie du système d'antenne et de l'oscillateur, et à délivrer un signal ayant une fréquence égale à la différence entre la fréquence radio et la fréquence d'oscillation.

L'invention sera mieux comprise à l'aide de la description suivante, faite à titre d'exemple non-limitatif et en regard des dessins annexés, dans lesquels :

- la figure 1 est un schéma fonctionnel partiel décrivant un appareil récepteur de signaux radioélectriques mettant en oeuvre l'invention,
- la figure 2 est un schéma fonctionnel décrivant une boucle à verrouillage de phase selon l'invention, et
- la figure 3 est un schéma fonctionnel décrivant des moyens de correction indus dans un boude à verrouillage de phase conforme à un mode de réalisation préféré de l'invention.

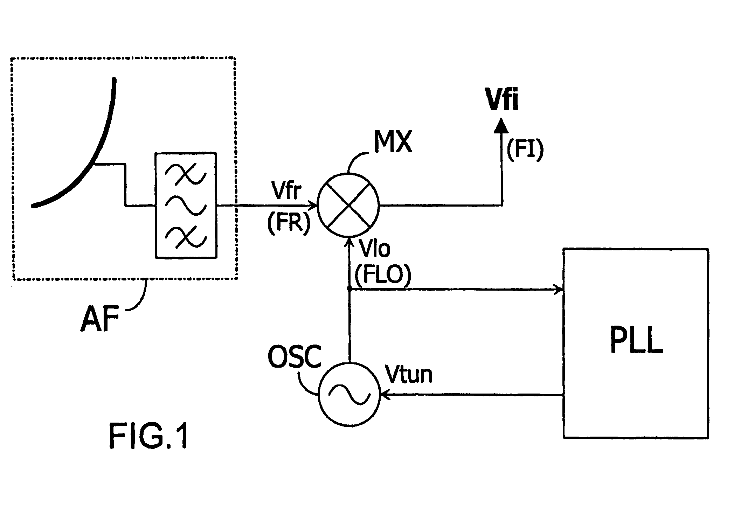

La figure 1 représente schématiquement un appareil récepteur de signaux radioélectriques, par exemple un récepteur de signaux de télévision, comportant un étage d'entrée AF, par exemple un système d'antenne et de filtrage, permettant la réception d'un signal dont la fréquence est sélectionnée au sein d'une gamme de fréquences donnée, et sa transformation en un signal électronique Vfr dit signal radio, ayant une fréquence FR appelée fréquence radio, appareil dans lequel une conversion de fréquence, à partir de la fréquence FR sélectionnée vers une fréquence intermédiaire FI prédéterminée, est réalisée au moyen d'un mélangeur MX destiné à recevoir le signal radio Vfr, d'une part, et le signal de sortie Vlo d'un oscillateur local OSC.
La fréquence intermédiaire FI est fixée et est égale à la différence entre la fréquence radio FR et la fréquence d'oscillation FLO du signal de sortie Vlo du premier oscillateur local OSC. Le choix de ladite fréquence d'oscillation FLO détermine donc la valeur de la fréquence radio FR sélectionnée.
Dans cet appareil, la fréquence d'oscillation FLO du signal de sortie Vlo du premier oscillateur local OSC est déterminée par un signal de réglage Vtun délivré par un module de réglage PLL, qui forme avec l'oscillateur local OSC une boude à verrouillage de phase

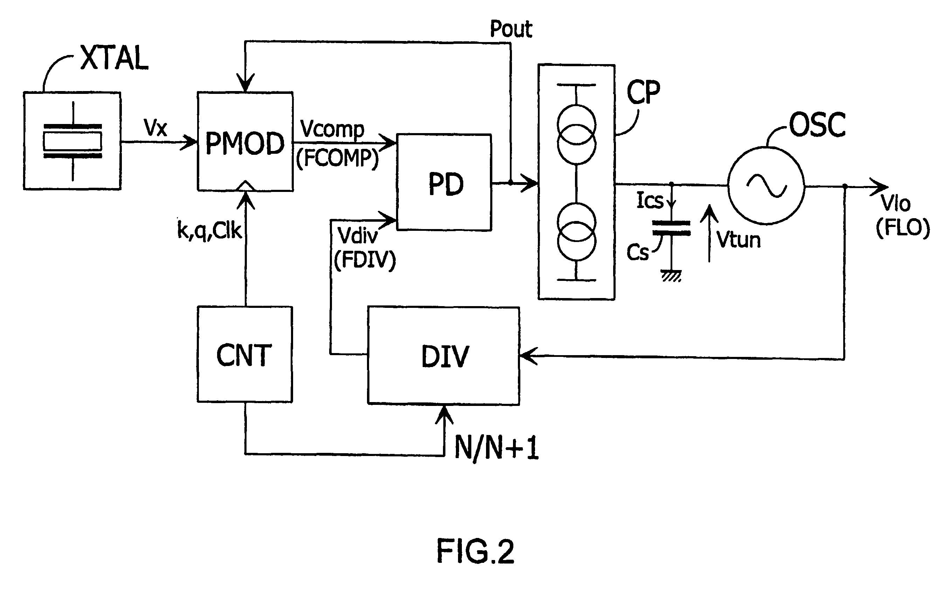

La figure 2 décrit plus en détail cette boude à verrouillage de phase, qui comporte :

- l'oscillateur local OSC destiné à délivrer le signal de sortie Vlo dont la fréquence FLO est déterminée par la valeur d'un signal de réglage Vtun,
- un diviseur de fréquence DIV, destiné à recevoir le signal de sortie Vlo de l'oscillateur local OSC, et à délivrer un signal de sortie Vdiv ayant une fréquence FDIV, un mot de consigne N/N+1 fourni par un module de contrôle CNT déterminant pour chaque cycle de la boucle la valeur instantanée du rapport de la division de fréquence effectuée par le diviseur DIV,
- un détecteur de phase/fréquence PD, destiné à comparer la fréquence FDIV du signal de sortie Vdiv du diviseur de fréquence DIV avec une fréquence de comparaison FCOMP d'un signal de comparaison Vcomp, provenant dans cet exemple d'un oscillateur à quartz XTAL, et à délivrer un signal de commande Pout représentatif du résultat de ladite comparaison, et
- une pompe de charge CP dont la conduction est destinée à être contrôlée par le signal de commande Pout, une sortie de la pompe de charge CP étant reliée à une capacité Cs destinée à générer à ses bornes le signal de réglage Vtun, qui est donc constitué id par une tension.

Si la fréquence d'oscillation FLO du premier oscillateur local OSC est inférieure à R fois la fréquence FCOMP du signal de comparaison Vcomp, le signal de commande Pout est positif, ce qui ordonne à la pompe de charge CP de délivrer un courant Ics positif. Ce courant, transmis à la capacité Cs, provoque un accroissement de la valeur de la tension de réglage Vtun prélevée aux bornes de la capacité Cs, et donc un accroissement de la fréquence d'oscillation FLO. Lorsque la fréquence d'oscillation FLO devient supérieure à celle du signal de comparaison Vcomp, le signal de commande Pout devient négatif, ce qui provoque une inversion du sens du courant Ics, qui devient négatif. Ce courant négatif, transmis à la capacité Cs, provoque une diminution de la valeur de la tension de réglage Vtun prélevée aux bornes de la capacité Cs, et donc une diminution de la fréquence d'oscillation FLO. La boude à verrouillage de phase tendra vers un régime d'équilibre, dans lequel FLO=R.FDIV=R.FCOMP.
Le diviseur de fréquence DIV est ici un diviseur du type «fractionnel-N», dont le rapport de division R entre la fréquence FLO de son signal d'entrée Vlo et la fréquence FDIV de son signal de sortie Vdiv s'exprime le plus souvent sous la forme R=FLO/FDIV=N+k/q, où N, k et q sont des paramètres entiers. En réalité, de tels diviseurs de fréquence opèrent une division par N pendant q-k cycles de fonctionnement de la boucle à verrouillage de phase, un cycle de fonctionnement correspondant à une période du signal Vdiv de sortie du diviseur de fréquence DIV, puis une division par N+1 pendant k cycles de fonctionnement de ladite boucle. Ainsi, la valeur moyenne du rapport de division sur q cycles de la boucle à verrouillage de phase est égale à N+k/q. La valeur du paramètre q est prédéterminée par la valeur de l'écart minimum entre deux fréquences d'oscillation, qui doit être maintenu constant. Ainsi, q=FCOMP/FSTEP, où FCOMP est la fréquence de comparaison choisie et FSTEP l'écart minimum. Dans l'exemple des signaux de télévision numériques hertziens cités plus haut, FSTEP=166,67kHz, ce qui impliquera que q=24 si l'on choisit FCOMP=4MHz.
Un régime d'équilibre de la boude à verrouillage de phase est défini comme étant celui au cours duquel est vérifiée la relation suivante : FDIV=R.FLO=FCOMP. Cela signifie qu'à l'issue de q cycles de fonctionnement de la boucle à verrouillage de phase, le signal de sortie Vdiv du diviseur de fréquence DIV et le signal de comparaison Vcomp doivent être en phase et avoir des fréquences égales, c'est-à-dire qu'à l'issue de q cycles de fonctionnement, aucune correction ne doit être en principe apportée à la valeur de la fréquence d'oscillation FLO. Or, on constate en réalité dans les boucles à verrouillage de phase connues qu'à l'issue de chaque cycle au cours duquel le rapport de division R du diviseur de fréquence DIV est égal à N, le signal de sortie Vdiv du diviseur de fréquence DIV présente un déphasage par rapport au signal de comparaison Vcomp, puisque sa fréquence FDIV est légèrement plus élevée que la fréquence de comparaison FCOMP, FDIV étant égale à FLO/N tandis que FCOMP=FLO/(N+k/q). Bien que de tels déphasages se trouvent théoriquement compensés lors des cycles au cours desquels le rapport de division R du diviseur de fréquence DIV est égal à N+1, en pratique, tout déphasage est détecté par le détecteur de phase/fréquence PD qui provoque automatiquement une correction inutile et intempestive de la valeur de la fréquence d'oscillation FLO. De telles corrections génèrent une modulation de phase parasite du signal de sortie Vlo de l'oscillateur OSC autour de sa fréquence d'oscillation centrale FLO, c'est-à-dire que la valeur instantanée de la fréquence d'oscillation FLO varie au cours du régime d'équilibre. Or la boucle à verrouillage de phase a pour fonction de générer un signal Vlo ayant une fréquence d'oscillation FLO servant de référence pour la sélection d'une fréquence radio FR, ainsi qu'exposé précédemment.

La boucle à verrouillage de phase selon l'invention contient donc des moyens de correction PMOD destinés à détecter une modulation de phase parasite appliquée au signal de sortie Vlo de l'oscillateur, et à appliquer au signal de comparaison Vcomp une modulation de phase similaire à ladite modulation de phase parasite.

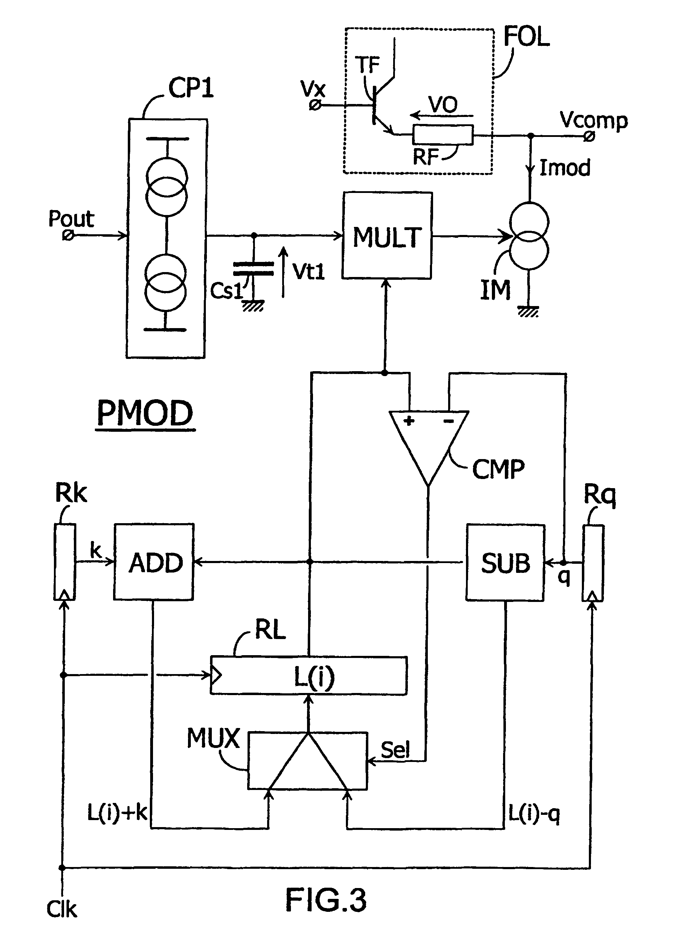

La figure 3 décrit un mode de réalisation préféré des moyens de correction PMOD. Ces moyens contiennent :

- des moyens de stockage (CP1, Cs1) pour mémoriser la valeur Vt1 prise par le signal de réglage à l'issue de q cycles de la boude à verrouillage de phase, et
- des moyens de déphasage (RL, Rk, Rq, MULT, FOL), pour appliquer au signal de comparaison Vcomp, à chaque ième (pour i=1 à q) cycle de la boucle à verrouillage de phase, un déphasage dont la valeur est déterminée par le produit entre la valeur Vt1 mémorisée par les moyens de stockage (CP1, Cs1) et un coefficient L(i) propre au cycle considéré.

Les moyens de stockage sont id constitués par une pompe de charge CP1 identique à la pompe de charge CP décrite précédemment, destinée à charger ou à décharger une capacité Cs1 identique à capacité Cs décrite précédemment, en fonction de la valeur du signal de commande Pout généré par le détecteur de phase/fréquence PD. La tension Vt1 ainsi générée aux bornes de la capacité Cs1 est donc théoriquement identique au signal de réglage Vtun.

Les moyens de déphasage comportent trois registres RL, Rk et Rq, destinés à être rechargés lorsqu'un signal d'horloge Clk, fourni par le module de contrôle CNT représenté à la figure 2, présente un front actif, par exemple un front montant. Les registres Rk et Rq reçoivent de la part du module de contrôle les valeurs des paramètres k et q. Le registre RL contient, lui, la valeur du coèffident L(i) pour le cycle en cours.

Les moyens de déphasage contiennent en outre un additionneur numérique ADD, destiné à recevoir sur une entrée la valeur du coefficient L(i), et sur une autre entrée la valeur du paramètre k. Les moyens de déphasage contiennent de plus un soustracteur numérique SUB, destiné à recevoir sur une entrée la valeur du coefficient L(i), et sur une autre entrée la valeur du paramètre q. Les moyens de déphasage contiennent également un multiplexeur numérique MUX dont deux entrées de données sont reliées aux sorties de l'additionneur ADD et du soustracteur SUB, et dont une sortie de données est reliée au registre RL. Au cours de chaque ième cycle (pour i=1 à q) de fonctionnement de la boucle à verrouillage de phase, un comparateur numérique CMP compare la valeur du troisième paramètre q à celle du coefficient L(i) correspondant audit cycle, et délivre au multiplexeur MUX un signal de sélection Sel représentatif du résultat de la comparaison. Si L(i)<q, le signal de sélection Sel est à l'état inactif, par exemple au niveau logique 0, et c'est la sortie de l'additionneur ADD qui est reliée au registre RL via le multiplexeur MUX. Inversement, si L(i)>q, le signal de sélection Sel est à l'état actif, par exemple au niveau logique 1, et c'est la sortie du soustracteur SUB qui est reliée au registre RL via le multiplexeur MUX. Au début du cycle suivant i+1, le module de contrôle imprime un front actif au signal d'horloge Clk, et le registre RL mémorise un nouveau coefficient L(i+1) adapté à ce cycle, dont la valeur est la valeur du signal présent à la sortie du multiplexeur MUX. La valeur de chaque chaque coefficient L(i) (pour i=1 à q) est déterminée par les relations :

$$L(i)=L(i-1)+k, \text{ si } L(i-1)<q,$$

et

$$L(i)=L(i-1)-q, \text{ si } L(i-1)>q.$$

Un multiplieur MULT effectue une multiplication entre la valeur Vt1 mémorisée par les moyens de stockage (CP1, Cs1) et la valeur du coefficient L(i) pour le cycle en cours. Le résultat de cette multiplication détermine la valeur d'un courant Imod produit par une source de courant variable IM, laquelle sera construite de sorte que Imod=M.L(i).Vt1, où M est une constante intrinsèque à la liaison entre le multiplieur MULT et la source de courant IM.

Le signal de comparaison Vcomp provient d'un oscillateur à quartz via un étage suiveur FOL, contenant un transistor TF, destiné à recevoir sur sa base le signal de sortie Vx de l'oscillateur à quartz, et une résistance RF, reliée à la source de courant IM. La résistance RF produit alors un décalage en tension VO=RF.Imod=RF.M.L(i).Vt1, dont l'ampleur est donc proportionnelle à L(i) fois la valeur Vt1 mémorisée par les moyens de stockage (CP1, Cs1).

Du fait que le signal de sortie Vx de l'oscillateur à quartz présente une allure linéaire au voisinage de la valeur zéro, un décalage en tension du signal de comparaison Vcomp provoque un décalage temporel des passages par zéro dudit signal, passages par zéro qui constituent les évènements par rapport auxquels des fronts du signal de sortie du diviseur de fréquence sont comparés. La valeur du coefficient L(i) étant déterminée pour chaque cycle en tenant compte du rapport de division utilisé au cours de ce cycle, le déphasage ainsi imprimé au signal de comparaison Vcomp est tel que ledit signal sera systématiquement en phase avec le signal de sortie du diviseur de fréquence à l'issue de chaque cyde, quelle que soit la valeur du rapport de division au cours de ce cycle.

D'autres modes de réalisation des moyens de correction sont envisageables, qui peuvent faire appel à des éléments extérieurs à la boude à verrouillage de phase, mais l'exemple décrit ci-dessus présente l'avantage d'opérer une correction au sein même de la boucle à verrouillage de phase, d'une manière transparente pour son utilisateur.

## Revendications

1. Boucle à verrouillage de phase, incluant :

   . un oscillateur (OSC) destiné à produire un signal de sortie (Vlo) ayant une fréquence d'oscillation (FLO) dont la valeur dépend de celle d'un signal de réglage (Vtun),
   . un diviseur de fréquence (DIV) destiné à recevoir le signal de sortie de l'oscillateur et à délivrer un signal de sortie (Vdiv) ayant un fréquence (Fdiv) R fois inférieure à la fréquence d'oscillation, R étant un rapport de division pouvant être exprimé sous la forme R=N+k/q, où N, k et q sont des paramètres entiers, et
   . un détecteur de phase/fréquence (PD) destiné à comparer la fréquence du signal de sortie du diviseur avec une fréquence (FCOMP), dite de comparaison, d'un signal de comparaison (Vcomp), et à délivrer à l'oscillateur le signal de réglage dont la valeur est représentative du résultat de la comparaison, , boucle à verrouillage de phase,

   . des moyens de correction (PMOD, CNT) destinés à détecter une modulation de phase parasite appliquée au signal de sortie de l'oscillateur, et à appliquer au signal de comparaison une modulation de phase similaire à ladite modulation de phase parasite,

caractérisé en ce que le boucle à verrouillage de phase comprend :

   . des moyens de stockage (CP1, Cs1) pour mémoriser la valeur (Vt1) prise par le signal de réglage à l'issue de q cycles de la boucle à verrouillage de phase, et
   . des moyens de déphasage (RL, Rk, Rq, MULT, FOL) pour appliquer au signal de comparaison, à chaque ième (pour i=1 à q) cycle de la boucle à verrouillage de phase, un déphasage dont la valeur est déterminée par le produit entre la valeur mémorisée par les moyens de stockage et un coefficient L(i) propre au cycle considéré.

2. Boucle à verrouillage de phase selon la revendication 1, caractérisée en ce que la valeur de chaque coefficient L(i) (pour i=1 à q) est déterminée par les relations :

$$L(i)=L(i-1)+k, \text{ si } L(i-1)<q,$$

et

$$L(i)=L(i-1)-q, \text{ si } L(i-1)>q.$$

3. Boucle à verrouillage de phase selon la revendication 1, caractérisée en ce que les moyens de déphasage (RL, Rk, Rq, MULT, FOL) sont agencés pour appliquer au signal de comparaison (Vcomp), au cours de chaque ième (pour i=1 à q) cycle de la boucle, un décalage en tension (VO) dont l'ampleur est proportionnelle à L(i) fois la valeur (Vtl) mémorisée par les moyens de stockage (CP1, Cs1).

4. Appareil destiné à la réception de signaux radioélectriques, incluant :

   . un étage d'entrée (AF) destiné à recevoir un signal radioélectrique et à convertir ledit signal en un signal de sortie électronique (Vfr) ayant une fréquence dite fréquence radio (FR),
   . une boucle à verrouillage de phase (OSC, PLL) conforme à la revendication 1, destinée à ajuster la fréquence d'oscillation (FLO) du signal de sortie (Vlo) d'un oscillateur (OSC), et

un mélangeur (MX) destiné à recevoir les signaux de sortie de l'étage d'entrée et de l'oscillateur, et à délivrer un signal (Vfi) ayant une fréquence (FI) égale à la différence entre la fréquence radio et la fréquence d'oscillation.

**Patentansprüche**

1. Phasenverriegelungsschleife mit:

   . einem Oszillator (OSC) für die Erzeugung eines Ausgangssignals (Vlo) mit einer Oszillationsfrequenz (FLO), deren Wert von demjenigen eines Regelsignals (Vtun) abhängt,

   . einem Frequenzteiler (DIV) für den Erhalt des Ausgangssignals des Oszillators und die Ausgabe eins Ausgangssignals (Vdiv) mit einer Frequenz (Fdiv) R-mal unter der der Oszillationsfrequenz, wobei R ein Teilungsverhältnis ist, das in der Form R=N+k/q ausgedrückt werden kann, und N, k und q ganzzahlige Parameter sind, und

   . einem Phasen/Frequenz-Detektor (PD) fiir den Vergleich der Frequenz des Ausgangssignals des Teilers mit einer so genannten Vergleichsfrequenz (FCOMP) eines Vergleichssignals (Vcomp) und für die Ausgabe des Regelsignals an den Oszillator, dessen Wert repräsentativ für das Ergebnis des Vergleichs an der Phasenverriegelungsschleife ist,

   . Korrekturmittel (PMOD, CNT), für die Erkennung einer parasitären Phasenmodulation bestimmt und auf das Ausgangssignal des Oszillators angewandt, und für die Anwendung auf das Vergleichssignal einer mit der besagten parasitären Phasenmodulation similären Phasenmodulation,

   **dadurch gekennzeichnet, dass** die Phasenverriegelungsschleife enthält:

   . Speichermittel (CP1, Cs1) zum Abspeichern des am Ende von q Zyklen der Phasenverriegelungsschleife vom Regelsignal genommenen Wertes (Vt1), und

   . Phasenverschiebungsmittel (RL, Rk, Rq, MULT, FOL) zur Anwendung auf das Vergleichssignal in jedem i-ten (für i=1 bis q) Zyklus der Phasenverriegelungsschleife, eine Phasenverschiebung, deren Wert-aus dem Produkt des von den Speichermitteln gespeicherten Werts mit einem dem betrachteten Zyklus eigenen Koeffizienten L(i) bestimmt wird.

2. Phasenverriegelungsschleife nach Anspruch 1, **dadurch gekennzeichnet, dass** der Wert jedes Koeffizienten L(i) (für i=1 bis q) bestimmt wird mit den Relationen:

$$L(i)=L(i-1)+k, \text{ wenn } L(i-1)<q,$$

et

$$L(i)=L(i-1)-q, \text{ wenn } L(i-1)>q.$$

3. Phasenverriegelungsschleife nach Anspruch 1, **dadurch gekennzeichnet, dass** die Phasenverschiebungsmittel (RL, Rk, Rq, MULT, FOL) angeordnet sind, um im Laufe jedes i-ten (für i=1 bis q) Zyklus der Schleife eine Spannungsverschiebung (VO), deren Umfang proportional zu L(i)-mal dem von den Speichermitteln (CP I , Cs1) gespeicherten Wert (Vtl) ist, auf das Vergleichssignal (Vcomp) anzuwenden.

4. Gerät für den Empfang von Funksignalen mit:

   . einer Eingangsstufe (AF) für den Erhalt eines Funksignals und die Umwandlung des besagten Signals in ein elektronisches Ausgangssignal (Vfr) mit einer Funkfrequenz (FR) bezeichneten Frequenz,

   . einer Phasenverriegelungsschleife (OSC, PLL) nach Anspruch 1, bestimmt für die Anpassung der Oszillationsfrequenz (FLO) des Ausgangssignals (Vlo) eines Oszillators (OSC), und

   . einem Mischer (MX) für den Erhalt der Ausgangsignale der Eingangsstufe und des Oszillators, und für die Ausgabe eines Signals (Vfi) mit einer Frequenz (FI) gleich der Differenz zwischen der Funkfrequenz und der Oszillationsfrequenz.

**Claims**

1. A phase-locked loop, comprising:

   • an oscillator (OSC) intended to produce an output signal (Vlo) having an oscillation frequency (FLO) whose value depends on that of a tuning signal (Vtun),

   • a frequency divider (DIV) intended to receive the output signal from the oscillator and to supply an output signal (Vdiv) having a frequency (Fdiv) which is R times lower than the oscillation frequency, R being a division ratio that can be expressed as follows: R = N+k/q, where N, k and q are integer parameters, and

   • a phase/frequency detector (PD) intended to compare the frequency of the output signal of the divider with a so-called comparison frequency (FCOMP) of a comparison signal (Vcomp), and to supply the tuning signal, whose value is representative of the result of the comparison, to the oscillator,

- correction means (PMOD, CNT) intended to detect a parasitic phase modulation applied to the output signal of the oscillator, and to apply a phase modulation, which is similar to said parasitic phase modulation, to the comparison signal,

**characterized in that** the phase-locked loop includes:

- storage means (CP1, Cs1) for storing the value (Vt1) adopted by the tuning signal at the close of q cycles of the phase-locked loop, and
- phase-shifting means (RL, Rk, Rq, MULT, FOL) for applying a phase shift to the comparison signal at each $i^{th}$ (i = 1 to q) cycle of the phase-locked loop, the value of said phase shift being determined by the product of the value stored by the storage means and a coefficient L(i) that is specific to the cycle in question.

2. A phase-locked loop as claimed in claim 1, **characterized in that** the value of each coefficient L(i) (i = 1 to q) is determined by the following relations:

$$L(i) = L(i-1)+k, \text{ if } L(i-1) < q,$$

and

$$L(i) = L(i-1)-q, \text{ if } L(i-1) > q.$$

3. A phase-locked loop as claimed in claim 1, **characterized in that** the phase-shifting means (RL, Rk, Rq, MULT, FOL) are designed so as to apply a voltage shift (VO) to the comparison signal (Vcomp) in the course of each $i^{th}$ (i = i to q) cycle of the loop, the size of said voltage shift being proportional to L(i) times the value (Vtl) stored by the storage means (CP1, Cs1).

4. A device intended to receive radioelectric signals, including:

- an input stage (AF) intended to receive a radioelectric signal and to convert this signal to an electronic output signal (Vfr) having a so-called radio frequency (FR),
- a phase-locked loop (OSC, PLL) as claimed in claim 1, intended to adjust the oscillation frequency (FLO) of the output signal (Vlo) of an oscillator (OSC), and
- a mixer (MX) intended to receive the output signals from the input stage and the oscillator, and to supply a signal (Vfi) whose frequency (FI) is equal to the difference between the radio frequency and the oscillation frequency.

FIG.1

FIG.2

EP 1 133 060 B1

FIG.3